Europäisches Patentamt

European Patent Office

Office européen des brevets

(11) Numéro de publication: **0 090 727**
**A1**

## DEMANDE DE BREVET EUROPEEN

(21) Numéro de dépôt: **83400603.3**

(22) Date de dépôt: **23.03.83**

(51) Int. Cl.³: **H 05 K 7/20**

(30) Priorité: **26.03.82 FR 8205253**

(43) Date de publication de la demande: **05.10.83**
**Bulletin 83/40**

(84) Etats contractants désignés: **DE GB IT**

(71) Demandeur: **SOCAPEX, 10 bis, quai Léon-Blum,**
**F-92153 Suresnes (FR)**

(72) Inventeur: **Bricaud, Hervé, THOMSON-CSF SCPI 173, bld**
**Haussmann, F-75379 Paris Cedex 08 (FR)**
Inventeur: **Olive, Jean-Louis, THOMSON-CSF**
**SCPI 173, bld Haussmann, F-75379 Paris Cedex 08 (FR)**

(74) Mandataire: **Vesin, Jacques et al, THOMSON-CSF**
**SCPI 173, Bld Haussmann, F-75379 Paris Cedex 08 (FR)**

(54) **Carte imprimée électrique et thermique, procédé de fabrication d'une telle carte, et système d'interconnexion thermique et électrique utilisant une telle carte.**

(57) La présente invention concerne carte imprimée électrique et thermique, un procédé de fabrication d'une telle carte ainsi qu'un système d'interconnexion thermique et électrique utilisant cette carte. Selon l'invention, elle comporte, solidaires l'un de l'autre, un circuit imprimé (11) mono ou multi-couches et un drain thermique constitué d'une âme métallique (2) comportant des zones revêtues de résine isolante (3) et des zones non revêtues de résine isolante (4).

0090727

## CARTE IMPRIMEE ELECTRIQUE ET THERMIQUE, PROCEDE DE FABRICATION D'UNE TELLE CARTE ET SYSTEME D'INTERCONNEXION THERMIQUE ET ELECTRIQUE UTILISANT UNE TELLE CARTE

La présente invention concerne une carte imprimée électrique et thermique, un procédé de fabrication d'une telle carte ainsi qu'un système d'interconnexion thermique et électrique utilisant cette carte.

Les problèmes de dissipation thermique se posent notamment dans les appareils ou équipements comportant un grand nombre de cartes imprimées munies de composants électroniques. Parmi ces composants, certains d'entre eux dissipent une quantité de chaleur importante qu'il convient d'évacuer dans les meilleures conditions possibles afin de maintenir lesdits composants dans des conditions de fonctionnement acceptables.

La carte imprimée selon l'invention est caractérisée en ce qu'elle comporte, solidaire l'un de l'autre, un circuit imprimé mono ou multi-couches et un drain thermique constitué d'une âme métallique revêtue de résine isolante, le circuit imprimé et le drain thermique comportant une pluralité de trous de connexion respectivement alignés deux par deux, lesdits trous du drain thermique étant également revêtus de résine isolante, le drain thermique comportant en outre des zones non revêtues de résine isolante disposée sur la face extérieure de celui-ci. Ces zones non revêtues de résine isolante seront d'une part au moins une bordure de la carte imprimée, et d'autre part les emplacements prévus pour les composants électroniques dissipant de la chaleur.

De cette manière, en effet, on constate que la carte imprimée ainsi réalisée outre le fait que le drain thermique généralement métallique contribue à rigidifier le circuit imprimé qui peut être très mince, permet alors une dissipation thermique correcte des

2

composants électroniques, dissipation effectuée par conduction. En effet, chaque composant électronique, dissipant de la chaleur, est placé en un endroit de la carte comportant une partie non revêtue de résine isolante ce qui permet de mettre en contact thermique étroit le boîtier dudit composant et le drain thermique. Au besoin, pour améliorer la conduction thermique, on interpose entre les deux une pâte de conduction thermique bien connue de l'homme de métier ayant un coefficient de conduction thermique supérieure à celui de l'air. Les calories ainsi dissipées par le composant électronique et transmises à son boîtier sont alors drainées par le drain thermique jusque sur les bords latéraux de la carte qui comporte des bandes latérales non revêtues de résine isolante. Ces bandes latérales sont insérées dans des connecteurs thermiques réalisés sous forme de glissières dans lesquelles viennent se bloquer les extrémités de la carte en contact étroit avec lesdites glissières éventuellement traversées par un liquide de refroidissement.

Une telle structure de carte et de système d'interconnexion telle que décrit ci-dessus permet d'améliorer considérablement l'évacuation des calories dissipées par ses composants et permet ainsi une plus grande densité de carte à l'intérieur d'un même équipement électrique.

L'invention concerne également un procédé de fabrication d'une carte imprimée telle que décrit ci-dessus. Sans entrer dans les détails auxquels on pourra se reporter ci-après, ce procédé est essentiellement remarquable en ce que le drain thermique, généralement une plaque métallique, est percé tout d'abord de trous de connexion à travers lesquels passeront les connexions des composants de la carte. Ce perçage s'effectue en pratique à l'aide de la même bande de commande de la machine outil de perçage que le circuit imprimé qui lui est associé. Après perçage, on dépose sur le drain thermique aux endroits voulus des caches du type ruban adhésif de manière à repérer ces endroits. Une peinture isolante est ensuite déposée uniformément sur l'ensemble du drain y compris dans les trous. Ce dépôt s'effectue soit par la technique de peinture électrostatique, soit par la technique du lit fluidisé (voir pour plus de détail sur ces techniques employés dans le domaine des circuits imprimés le brevet français 2 386 959). Après polymérisation de la résine (généralement une résine époxy), le drain thermique est ainsi isolé uniformément. On retire alors les caches aux endroits où ils avaient été disposés mettant ainsi des zones à nu sur le drain thermique. Le circuit imprimé correspondant est ensuite réalisé et assemblé avec ce drain thermique de manière connue en soi, soit par contre-collage d'un circuit imprimé mono ou multi-couches réalisé sur tissu de verre époxy par exemple, soit par des techniques additives ou soustractives de dépôt métallique sur la résine isolante déposée sur le drain thermique. Suivant les cas, comme on le verra plus loin, l'étape de perçage du circuit imprimé peut être évitée, tandis que le circuit imprimé comporte alors des fenêtres qui viennent en coïncidence avec les zones mises à nu du drain thermique. Ces zones sont traitées ensuite pour être protégées contre l'oxydation, de manière connue en soi.

L'invention concerne également un système d'interconnexion thermique et électrique de composants électroniques dissipant de la chaleur, système utilisant une carte telle que décrite ci-dessus. La carte revêtue de composants électroniques aux endroits adéquats est disposée de préférence entre deux connecteurs thermiques sous forme de glissières situées de part et d'autre de la carte, tandis que la connexion électrique de la carte avec l'appareillage extérieur peut s'effectuer à l'aide de connecteurs électriques disposés sur l'un ou les deux autres bords de la carte. Bien entendu, les connecteurs thermiques utilisés peuvent être du type connecteurs électriques et thermiques tels que décrits dans le brevet français 2 471 059. Dans ce cas, les pistes de la carte imprimée sont en contact électrique avec les contacts de la glissière thermique, isolés entre eux de manière adéquate.

Dans toute la suite de l'exposé, le terme drain thermique désigne tout type de support métallique et/ou fibreux capable de conduire la chaleur. Ce support est également conducteur électrique, nécessitant, par conséquent, une isolation électrique en particulier des trous dans lesquels passent les pattes des composants.

L'invention sera mieux comprise à l'aide des exemples de réalisation suivants, donnés à titre non limitatif, conjointement avec les figures qui représentent :

- la figure 1, une vue partielle en coupe d'un système d'interconnexion utilisant une carte imprimée selon l'invention,

- la figure 2, une vue en coupe et une vue de dessus correspondantes d'une carte selon l'invention,

- la figure 3, une variante de la carte selon l'invention dans laquelle le drain thermique n'a aucune perforation,

- la figure 4, une vue partielle d'un trou de connexion selon une variante préférentielle.

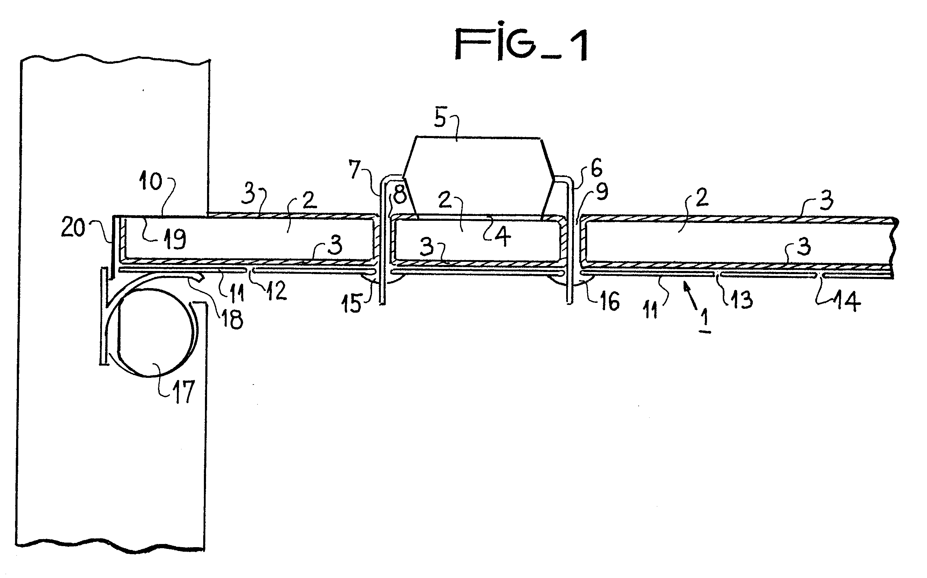

Sur la figure 1, est représentée une vue en coupe d'un système d'interconnexion électrique et thermique selon l'invention. La carte imprimée 1 selon l'invention est constituée d'un drain thermique métallique 2 sur lequel est déposée une couche isolante 3 telle qu'une résine époxy par exemple. Un circuit imprimé 11 muni de trous d'interconnexion entre couches telles que 12, 13, 14, etc... est rendu solidaire du drain thermique 2 sur la partie inférieure de celui-ci. La couche isolante 3 sépare du drain 2 des couches conductrices du circuit imprimé 11. Des trous de connexion 8 et 9 de composants tels que 5 traversent le drain thermique 2 et le circuit imprimé 11. Les pattes de connexion telles que 6 et 7 du composant 5 traversent ainsi ces trous revêtus intérieurement au niveau du drain thermique 2 de la couche isolante 3, lesdites pattes de connexion étant reliées en 15 et 16 au circuit imprimé 11. Sous le boîtier 5 du composant électronique, se trouve une partie 4 du drain thermique 2 non recouverte de la couche isolante 3, réalisant ainsi une ouverture dans cette couche isolante 3 qui recouvre par ailleurs le drain thermique 2. Pour améliorer la conduction thermique entre le boîtier 5 et le drain thermique 2, on peut incorporer dans cette ouverture 4 une pâte conductrice connue en soi ayant une bonne

5

conduction thermique. Sur l'extrémité supérieure gauche de la carte 1, la couche isolante 3 est interrompue mettant à nue ainsi une partie 19 du drain thermique 2 non revêtue de cette couche isolante. Cette partie 19 est au contact de la paroi 10 correspondante de la glissière thermique dans laquelle vient s'enficher l'extrémité de la carte. Le contact thermique est maintenu contre celle-ci à l'aide du contact presseur 18 maintenu en pression par la rotation de la came 17. L'extrémité du drain thermique 2 revêtue de la couche isolante 3 vient ici en butée contre le fond 20 de la rainure de la glissière thermique. On constate ici que le circuit imprimé 11 s'étend jusqu'à l'extrémité du drain thermique 2, séparée de celui-ci par la couche isolante 3. Cette figure illustre l'originalité du système d'interconnexion thermique selon l'invention dans lequel le composant 5 dissipant de la chaleur est placé côté drain thermique dans une ouverture du revêtement isolant 3 de celui-ci (meilleure conduction) tandis que ses connexions 6 et 7 traversent le drain dans des trous 8 et 9, isolés par le revêtement 3 également et puis traversent les trous correspondants sur le circuit imprimé sur la couche conductrice inférieure duquel elles sont fixées par les brasures 15 et 16. Ce dernier peut être, bien entendu, du type multi-couche, avec des pistes conductrices disposées côté drain thermique 2. De toutes manières, même lorsque ce dernier est conducteur électrique (comme l'aluminium), le revêtement isolant 3 qui recouvre tout le drain sauf aux endroits voulus, isole électriquement le drain thermique et les pistes du circuit imprimé. Les calories engendrées par le circuit 5 sont donc drainées par conduction vers la glissière thermique, via le drain thermique 2, la glissière thermique évacuant ensuite les calories de manière connue en soi vers l'extérieur du système.

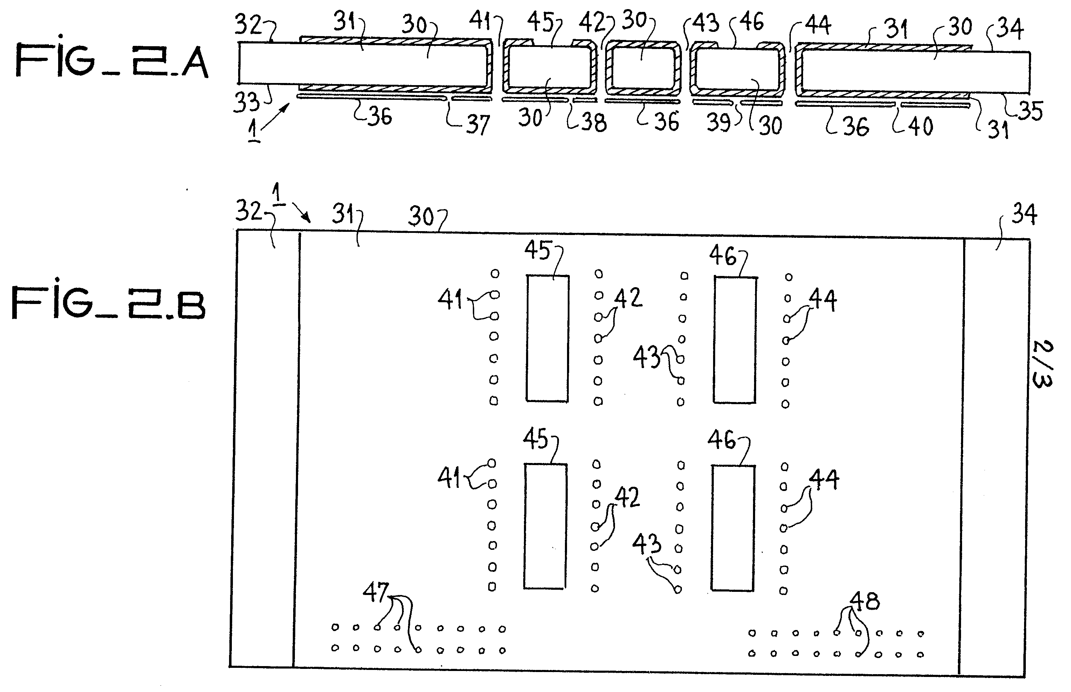

La figure 2 représente sur la figure 2a une vue en coupe d'une carte imprimée selon l'invention et sur la figure 2b une vue de dessus de cette carte. Cette carte 1 représente une variante de celle représentée sur la figure 1. En effet, sur cette figure 2, le drain thermique 30 n'est pas revêtu sur ses deux bordures latérales 32, 33 et 34, 35 de la couche isolante 31. Le drain thermique est ainsi directement au contact de la glissière thermique lorsque la carte est connectée, aussi bien sur une face que sur l'autre, le circuit imprimé 36 s'arrêtant avant l'extrémité latérale de la carte. Ce circuit imprimé 36 comporte également des trous d'interconnexion 37, 38, 39 et 40 entre les différentes couches qui le constituent. La carte imprimée 1 comporte par ailleurs des perforations 41, 42, 43, 44 traversant à la fois le drain thermique et le circuit imprimé est destiné au passage des connexions des composants électroniques à fixer sur cette carte. Ces trous de connexion sont isolés à l'aide de la couche isolante 31 dans les zones correspondantes du drain thermique. Celui-ci comporte sur sa face extérieure, des zones 45 et 46 non revêtues de la couche isolante 31. Ces zones correspondent aux emplacements des boîtiers de composants électroniques destinés à être fixés sur cette carte. On remarque par ailleurs des trous de connexion électrique 47 et 48 semblables aux trous tels que 41, 42, 43 et 44, et destinés à relier les conducteurs électriques du circuit imprimé 36 à l'extérieur de la carte, par l'intermédiaire de connecteurs de circuit imprimé bien connus de l'homme de métier.

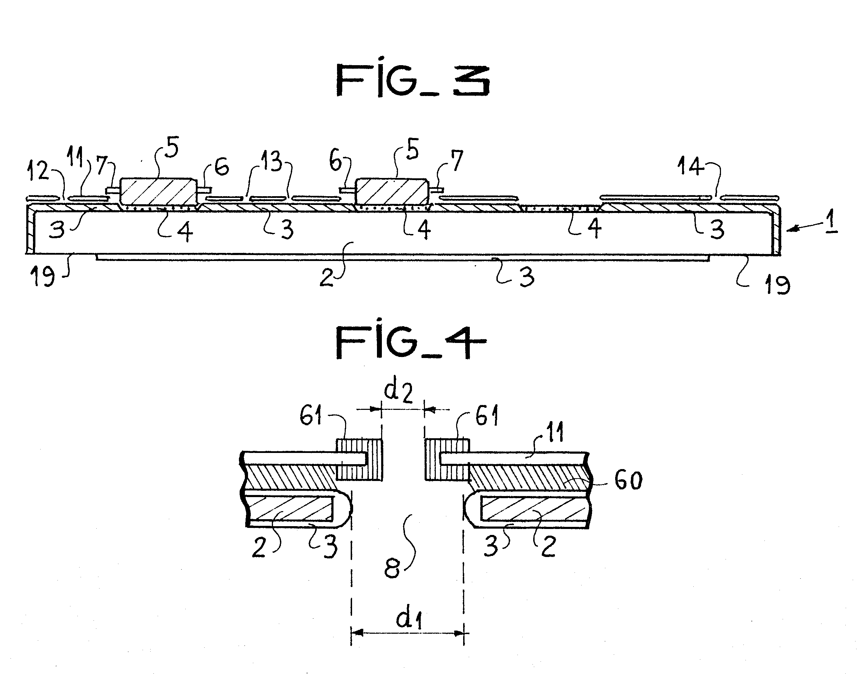

Sur la figure 3, est représentée une variante du circuit selon l'invention, variante de la figure 1 dans laquelle le drain thermique ne comporte aucune perforation. Sur cette figure, les mêmes éléments que ceux de la figure 1 portent les mêmes références. Le drain thermique 2 est recouvert sur sa face antérieure d'une couche uniforme de pâte isolante 3 sauf sur les deux bords latéraux 19 destinés à être en contact thermique avec les glissières thermiques telles que représentées sur la figure 1. Sur la face supérieure du drain thermique, se trouvent le circuit imprimé 11 et ses trous d'interconnexion entre couches telles que 12, 13 et 14. Ce circuit d'interconnexion 11 comporte au niveau des composants tels que 5 des ouvertures qui se prolongent également dans la couche isolante 3 du drain thermique 2. Les composants 5 qui sont du type par report à plat, c'est-à-dire munis soit de plots de connexions, soit de connexions latérales pouvant être soudées à plat sur les circuits imprimés (connexions 6 et 7 sur la figure 3), sont alors fixés sur le circuit imprimé 11 dans l'ouverture correspondante, cette ouverture étant munie sur sa partie inférieure d'un joint thermique 4 connu en soi, qui relie thermiquement la base du boîtier 5 au drain thermique 2. On constate dans cette variante que le drain thermique n'a pas besoin d'être perforé puisque les composants ne traversent pas celui-ci, ce qui permet encore d'améliorer l'évacuation des calories du fait de la continuité du métal constituant le drain thermique. On peut noter par ailleurs que la couche de protection 3 située au dos du drain thermique n'est pas nécessaire dans le cas présent et elle peut éventuellement être supprimée de manière à rapporter par exemple un radiateur de refroidissement par convection sur l'ensemble de la partie inférieure du drain thermique 2. On constate également que les zones 19 du drain thermique non pourvues de couches isolantes 3 sont situées dans le cas représenté sur la figure 3 au dos du drain thermique.

La figure 4 représente une vue partielle d'un trou de connexion selon une variante préférentielle de l'invention. Sur cette figure, les mêmes éléments que ceux de la figure 1 portent les mêmes références. Dans cette variante correspondant à la structure de la figure 1, l'ouverture réalisée dans le drain thermique a une largeur $d_1$ supérieure à l'ouverture pour le passage de la connexion du composant et sa soudure sur le circuit imprimé 11 qui a une largeur $d_2$ entre les deux extrémités de la pastille rapportée 61. Ceci permet une utilisation du circuit selon l'invention pour tous les types de boîtiers en particulier pour ceux qui présentent un épaulement au niveau des pattes de connexion évitant ainsi un contact des pattes avec la couche isolante 3 au moment de l'insertion. On notera également sur cette figure la couche d'adhésif 60 nettement mise en évidence entre le circuit imprimé 11 et le drain thermique 2 recouvert de sa couche isolante 3.

8

EXEMPLE :

On réalise un circuit imprimé doubles faces ou multi-couches en stratifié verre époxy mince selon la technique bien connue.

Un support métallique d'épaisseur 1 mm est ensuite percé de la même manière que le perçage des trous de connexion de composants du circuit imprimé multi-couches. Cette âme métallique est en aluminium ou ses alliages, cuivre, acier, ferro-nickel, titane avec un coefficient de dilatation compatible avec celui des céramiques. Elle est ensuite munie de caches ou zones épargnes aux endroits correspondant au boîtier des composants électroniques qui seront placés sur la carte ainsi que sur les deux bordures latérales opposées correspondant à la connexion thermique. Ce substrat métallique est ensuite plongé dans un lit fluidisé de résine époxy, la résine venant se disposer uniformément sur toute la plaque métallique. Le substrat métallique est alors retiré de ce lit fluidisé et l'on découpe ensuite la résine aux endroits repérés par les caches, après passage dans un four de manière à réaliser une réticulation ou durcissement de la résine époxy réalisant ainsi une couche isolante superficielle uniforme sur l'ensemble du drain thermique y compris dans les trous de connexion. Des détails sur ce procédé de dépôt de couches isolantes et leur mise en oeuvre sont donnés par exemple dans le brevet français 2 386 959. On pourra également procéder par dépôt électrostatique de peinture à travers des masques protégeant les parties situées sous les composants et les bordures de la carte de manière à réaliser directement la couche isolante adéquate.

Le circuit imprimé multi-couches et le drain thermique ainsi revêtus de sa couche isolante sont ensuite contre-collés à l'aide d'une colle époxy par exemple. On peut également utiliser un circuit imprimé sur verre époxy du type pré-impégné à l'aide d'une résine époxy pré-polymère, le passage en température de l'ensemble drain thermique et circuit imprimé réalisant la solidarisation de ces deux éléments.

9

REVENDICATIONS

1. Carte imprimée électrique et thermique, caractérisée en ce qu'elle comporte, solidaires l'un de l'autre, un circuit imprimé (11) mono ou multi-couches et un drain thermique constitué d'une âme métallique (2) comportant des zones revêtues de résine isolante (3) et des zones non revêtues de résine isolante (4).

2. Carte imprimée selon la revendication 1, caractérisée en ce que des zones (4) sans résine isolante sont situées sur la face extérieure du drain thermique (2) pour recevoir les composants correspondants (5), le circuit imprimé et le drain thermique comportant une pluralité de trous de connexion (8) respectivement alignés deux par deux, lesdits trous du drain thermique étant revêtus de résine isolante.

3. Carte imprimée selon la revendication 1, caractérisée en ce que le circuit imprimé (1) comporte des ouvertures en concordance avec des zones (4) non revêtues de résine isolante du drain thermique (2) pour recevoir les composants correspondants (5).

4. Carte imprimée selon l'une des revendications 1 à 3, caractérisée en ce que le drain thermique comporte également des zones (19) non revêtues de résine isolante en bordure de celui-ci, sur l'une et/ou l'autre face.

5. Carte imprimée selon l'une des revendications 1 à 4, caractérisée en ce que sur une bordure au moins de la carte sont prévus des emplacements de connexion électrique.

6. Procédé de fabrication d'une carte imprimée, caractérisé en ce qu'il consiste à réaliser un drain thermique à l'aide d'une plaque métallique (2) sur lequel on dispose des caches aux endroits voulus, on dépose ensuite une couche isolante (3) sur l'ensemble de la plaque métallique, on enlève les caches de manière à mettre à nu la plaque métallique dans les zones prévues (4) puis on réalise un circuit imprimé (11) qui est rendu solidaire de l'une des faces du drain thermique, de manière à rendre accessible les zones (4) de la plaque métallique mises à nu.

7. Système d'interconnexion thermique et électrique d'au moins un composant électronique (5) dissipant de la chaleur, comportant une carte imprimée constituée d'un drain thermique (2) d'une part et d'un circuit imprimé (11) d'autre part, chaque composant électronique (5) étant relié électriquement au circuit imprimé (11) et thermiquement au drain thermique (2), caractérisé en ce que le drain thermique est constitué d'une âme métallique (2) revêtue d'une couche électriquement isolante (3), cette couche comportant sur l'une des faces du drain thermique au moins un logement accessible (4) sur lequel est disposé le composant électronique (5), ledit circuit imprimé étant fixé à la couche de résine isolante disposée sur l'autre face dudit drain (2), le drain thermique comportant en outre des trous (8, 9), isolés électriquement par la couche isolante (3), disposés en coïncidence avec des trous (8, 9) du circuit imprimé, les pattes de connexion électrique (6, 7) dudit composant (5) traversant lesdits trous (8, 9) et étant fixées électriquement audit circuit imprimé, de manière à réaliser dans le logement (4) un bon contact thermique du composant (5) et du drain thermique (2).

8. Système d'interconnexion thermique et électrique selon la revendication 7, caractérisé en ce qu'une pâte de conduction thermique est interposée entre les boîtiers (5) de chaque composant et le drain thermique (2, 3).

9. Système d'interconnexion thermique et électrique selon l'une des revendications 7 ou 8, caractérisé en ce que le drain thermique comporte également au moins une bordure latérale (19) non recouverte par la couche de résine isolante (3), cette bordure (19) étant au contact de la paroi (10) d'un connecteur thermique (17, 18) de manière à drainer les calories dégagées par le composant (5) vers ledit connecteur thermique par l'intermédiaire du drain thermique (2).

10. Système d'interconnexion thermique et électrique selon la revendication 9, caractérisé en ce que le circuit imprimé (11) s'étend sensiblement jusqu'au bord du drain thermique (2) situé sous une bordure (19) et est relié électriquement au connecteur thermique par l'intermédiaire des contacts (18).

Fig_1

FIG_2.A

FIG_2.B

0090727

# FIG_3

# FIG_4

0090727

## Office européen des brevets

## RAPPORT DE RECHERCHE EUROPEENNE

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| X | FR-A-2 423 953 (R.T.C. LA RADIOTECHNIQUE-COMPELEC) * Page 9, ligne 21 - page 10, ligne 35; figure 3 * | 1-3 | H 05 K    7/20 |
| | --- | | |
| X | MACHINE DESIGN, vol. 48, no. 9, avril 1976, page 36, Cleveland, USA "Piggyback plate cools PC components" * Page 36 * | 1-2 | |
| | --- | | |
| X | DE-A-2 743 647 (SIEMENS AG.) * Page 4, line 1 - page 5, line 32 * | 1-2 | |
| | --- | | |
| A | DE-A-1 965 851 (GENERAL MOTORS CORP.) | | DOMAINES TECHNIQUES RECHERCHES (Int. Cl. 3) |
| | --- | | |
| A | EP-A-0 006 810 (LE MATERIEL TELPHONIQUE) | | H 05 K |
| | ----- | | |

Le présent rapport de recherche a été établi pour toutes les revendications

| Lieu de la recherche | Date d'achèvement de la recherche | Examinateur |
|---|---|---|
| LA HAYE | 14-07-1983 | SCHUERMANS N.F.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant